# EUROPEAN PATENT APPLICATION

(11) **EP 4 451 057 A1**
(43) Date of publication of application: **23.10.2024**
(21) Application number: 23731498.4
(22) Date of filing: 02.02.2023
(51) Int. Cl.: G03F 1/32

(54) **PHOTOMASK BLANK, PHOTOMASK, AND METHOD FOR MANUFACTURING PHOTOMASK**

(30) Priority: 15.12.2021 JP 2021203513
(71) Applicant: Toppan Photomask Co., Ltd., Tokyo 108-0023 (JP)
(72) Inventor: MATSUI, Kazuaki, Tokyo 108-0023 (JP); KOJIMA, Yosuke, Tokyo 108-0023 (JP)
(74) Representative: Hoffmann Eitle
(86) International application number: PCT/JP2023/003372
(87) International publication number: WO 2023/113047

(57) **Abstract**

Provided are a photomask blank capable of forming a nanofabrication resist pattern on a resist film with a high accuracy, a method for manufacturing a photomask, and a photomask manufactured by the method. A mask blank (100) according to the present embodiment is a mask blank used to manufacture a phase shift mask (200), to which exposure light having a wavelength of 200 nm or less is applied, and includes, in the following order, a translucent substrate (1), a phase shift film (2), and a light shielding film (3), and a hard mask film (4), in which the light shielding film (3) is formed of a material containing Cr, the hard mask film (4) includes a lower layer (41) positioned on a side of the light shielding film (3), and an upper layer (42) configuring an outermost layer of the hard mask film (4), the lower layer (41) contains at least one selected from Ta, Te, Ru, and a compound thereof, the upper layer (42) contains Ta or a Ta compound, and the compound contains at least one selected from O, N, and C.

## Description

### Technical Field

The present invention relates to a photomask blank, a photomask, and a method for manufacturing a photomask.

### Background Art

As a mask blank of a halftone type phase shift mask, a mask blank having a structure, in which a halftone phase shift film consisting of a metal silicide-based material, a light shielding film consisting of a chromium-based material, and an etching mask film (a hard mask film) consisting of an inorganic material are deposited on a translucent substrate, has been known in the related art. In a case of manufacturing a phase shift mask using this mask blank, first, the etching mask film is patterned by dry etching with a fluorine-based gas using a resist pattern formed on a surface of the mask blank as a mask, then, the light shielding film is patterned by dry etching with a mixed gas of chlorine and oxygen using the etching mask film as a mask, and the phase shift film is further patterned by dry etching with a fluorine-based gas using the pattern of the light shielding film as a mask.

Here, the resist pattern described above is formed by forming a resist film on the surface of the mask blank and drawing the resist film with an electron beam drawing machine in many cases. In this case, due to an influence of charging of the resist film (so-called charge-up of the resist film) by electrons emitted from the electron beam drawing machine, the electrons from the electron beam drawing machine may be emitted to an unexpected point to decrease a position accuracy of a drawing pattern.

As a technology for suppressing this charging phenomenon, for example, there is a technology for correcting the electron beam drawing machine (see PTL 1) or a technology for coating a conductive film (charge dissipation layer (CDL)) on the resist film.

### Citation List

### Patent Literature

PTL 1: JP 2019-204857 A

### Summary of Invention

### Technical problem

In a technology for correcting an electron beam drawing machine, which is one of technologies of the related art, it cannot be said that an effect of suppressing a charging influence by correction or an amount of improvement of a position accuracy is sufficient in manufacturing an advanced photomask (a next-generation photomask).

In addition, with respect to charge suppression of a resist film by CDL coating, which is one of technologies of the related art and is currently the mainstream, it is necessary to use the CDL having increased conductivity when it is necessary to further ensure the conductivity in the future. However, in a case of imparting higher conductivity to the CDL, it is necessary to increase acidity thereof, and there is a concern about mixing with the resist film. Therefore, a big issue arises when an advanced resist film (next-generation resist film) is used. That is, in the technology for charge suppression with the CDL, it is necessary to consider compatibility (affinity or combination) between the resist film and the CDL, and thus, it is difficult to say that the technology using the CDL is a highly general-purpose technology for charge suppression.

The present invention has been made to solve the above-described problems, and an object of the present invention is to provide a photomask blank capable of improving a position accuracy of electron beam irradiation by suppressing charge of a resist film at the time of electron beam drawing, that is, capable of forming a nanofabrication resist pattern on the resist film with high accuracy.

In addition, the present invention provides a method for manufacturing a photomask capable of forming a nanofabrication pattern on a thin film for pattern formation with high accuracy using this photomask blank, and a photomask manufactured by the manufacturing method.

### Solution to Problem

A photomask blank according to an aspect of the present invention is used to manufacture a photomask, to which exposure light having a wavelength of 200 nm or less is applied, and includes, in the following order, a transparent substrate, a thin film, and a hard mask film in this order, the thin film is formed of a material containing chromium, the hard mask film includes a lower layer positioned on a side of the thin film, and an upper layer configuring an outermost layer of the hard mask film, the lower layer contains at least one selected from tungsten, tellurium, ruthenium, and a compound of tungsten, tellurium, or ruthenium, the upper layer contains tantalum or a tantalum compound, and the compound contains at least one selected from oxygen, nitrogen, and carbon.

In addition, a thickness of the upper layer configuring the photomask blank according to an aspect of the present invention may be 1 nm or more.

In addition, a thickness of the hard mask film configuring the photomask blank according to an aspect of the present invention may be in a range of 4 nm or more and 14 nm or less.

In addition, the thin film configuring the photomask blank according to an aspect of the present invention may be a light shielding film.

In addition, the photomask blank according to an aspect of the present invention may further include, between the transparent substrate and the light shielding film, a phase shift film consisting of a material containing silicon.

A photomask according to an aspect of the present invention is a photomask, to which exposure light having a wavelength of 200 nm or less is applied, and includes a transparent substrate, a thin film which is formed on the transparent substrate and on which a pattern is formed, and a hard mask film formed on the thin film, the thin film is formed of a material containing chromium, the hard mask film includes a lower layer positioned on a side of the thin film, and an upper layer configuring an outermost layer of the hard mask film, the lower layer contains at least one selected from tungsten, tellurium, ruthenium, and a compound of tungsten, tellurium, or ruthenium, the upper layer contains tantalum or a tantalum compound, and the compound contains at least one selected from oxygen, nitrogen, and carbon.

In addition, a thickness of the upper layer configuring the photomask according to an aspect of the present invention may be 1 nm or more.

In addition, a thickness of the hard mask film configuring the photomask according to an aspect of the present invention may be in a range of 4 nm or more and 14 nm or less.

In addition, the thin film configuring the photomask according to an aspect of the present invention may be a light shielding film.

In addition, the photomask according to an aspect of the present invention may further include, between the transparent substrate and the light shielding film, a phase shift film consisting of a material containing silicon.

A method for manufacturing a photomask according to an aspect of the present invention using the photomask blank described above includes forming a resist pattern on the hard mask film of the photomask blank, forming a hard mask pattern by performing dry etching on the hard mask film with a fluorine-based gas using the resist pattern as a mask, and forming a thin film pattern by performing dry etching on the thin film with a mixed gas of chlorine and oxygen using the hard mask pattern as a mask.

In addition, a method for manufacturing a photomask according to another aspect of the present invention using the photomask blank described above includes forming a resist pattern on the hard mask film of the photomask blank, forming a hard mask pattern by performing dry etching on the hard mask film with a fluorine-based gas using the resist pattern as a mask, forming a light shielding film pattern by performing dry etching on the light shielding film with a mixed gas of chlorine and oxygen using the hard mask pattern as a mask, and removing the hard mask pattern while forming a phase shift film pattern by performing dry etching on the phase shift film with a fluorine-based gas using the light shielding film pattern as a mask.

### Advantageous Effects of Invention

According to the photomask blank according to an aspect of the present invention having the configuration described above, it is possible to improve a position accuracy of electron beam irradiation by suppressing charge of a resist film at the time of electron beam drawing, that is, it is possible to form a nanofabrication resist pattern on the resist film with high accuracy.

In addition, according to the method for manufacturing the photomask according to an aspect of the present invention having the configuration described above, it is possible to form a nanofabrication pattern on a thin film for pattern formation with high accuracy.

### Brief Description of Drawings

FIG. 1 is a schematic cross-sectional view illustrating a structure of a photomask blank according to an embodiment of the present invention;
FIG. 2 is a schematic cross-sectional view illustrating a step for manufacturing a photomask according to an embodiment of the present invention; and
FIG. 3 is a schematic cross-sectional view illustrating a structure of a photomask according to a modified example of an embodiment of the present invention.

### Description of Embodiments

Hereinafter, a specific configuration of each embodiment of the present invention will be described with reference to the drawings. The same constituent elements of each drawing are described using the same reference numerals.

### <Photomask blank>

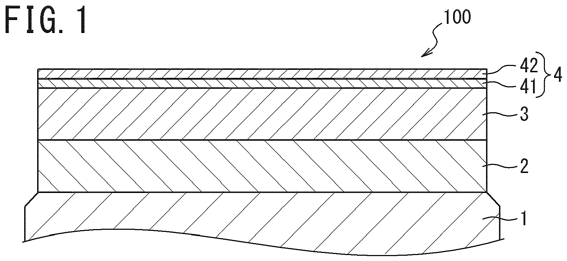

FIG. 1 illustrates a schematic configuration of an embodiment of a photomask blank (hereinafter, also simply referred to as a "mask blank"). A mask blank 100 illustrated in FIG. 1 has a configuration in which a phase shift film 2, a light shielding film 3, and a hard mask film 4 are deposited in this order on one main surface of a translucent substrate (transparent substrate) 1. In addition, the mask blank 100 may have a configuration in which a resist film is deposited on the hard mask film 4, if necessary. Hereinafter, the details of main constituent portions of the mask blank 100 will be described.

### [Translucent substrate]

The translucent substrate 1 consists of a material having an excellent transmission property with respect to exposure light used in an exposure step in lithography. As such a material, synthetic quartz glass, aluminosilicate glass, soda lime glass, low-thermal expansion glass (SiO₂-TiO₂ glass or the like), and other various glass substrates can be used. Particularly, a substrate using the synthetic quartz glass can be suitably used as the translucent substrate 1 of the mask blank 100 since it has a high transmission property with respect to ArF excimer laser light (wavelength: approximately 193 nm).

The exposure step in the lithography referred to herein is an exposure step in the lithography using a phase shift mask manufactured using this mask blank 100, and hereinafter, the exposure light is an exposure light used in the exposure step. As the exposure light, any of ArF excimer laser light (wavelength: 193 nm), KrF excimer laser light (wavelength: 248 nm), i-ray light (wavelength: 365 nm) can be applied, however, from a viewpoint of nanofabrication of a phase shift film pattern in the exposure step, the ArF excimer laser light can be applied to the exposure light. Therefore, hereinafter, an embodiment in a case where the ArF excimer laser light is applied to the exposure light will be described.

### [Phase shift film]

The phase shift film 2 has optical characteristics that an exposure light which has a predetermined transmittance with respect to an exposure light used in an exposure transfer step and has transmitted through the phase shift film 2, and an exposure light which has transmitted an atmosphere by the same distance as a thickness of the phase shift film 2 have a predetermined phase difference.

The phase shift film 2 is preferably formed of a material containing silicon (Si). In addition, the phase shift film 2 is more preferably formed of a material containing nitrogen (N) in addition to silicon. The phase shift film 2 uses a material capable of being patterned by dry etching using a fluorine-based gas and has sufficient etching selectivity for the light shielding film 3 containing chromium which will be described later.

In addition, the phase shift film 2 may further contain one or more elements selected from a semi-metal element, a non-metal element, and a metal element, as long as the patterning can be performed by the dry etching using the fluorine-based gas.

Of these, the semi-metal element may be any semi-metal element in addition to silicon. The non-metal element may be any non-metal element in addition to nitrogen, and preferably contains, for example, one or more elements selected from oxygen (O), carbon (C), fluorine (F), and hydrogen (H). Examples of the metal elements include molybdenum (Mo), tungsten (W), titanium (Ti), tantalum (Ta), zirconium (Zr), hafnium (Hf), niobium (Nb), vanadium (V), cobalt (Co), chromium (Cr), nickel (Ni), ruthenium (Ru), tin (Sn), boron (B), and germanium (Ge).

The phase shift film 2 is configured with, for example, MoSiON or MoSiN, a refractive index n, an extinction coefficient k, and a film thickness of the phase shift film 2 are respectively selected to satisfy a predetermined phase difference (for example, 150 [deg] to 210 [deg]) and a predetermined transmittance (for example, 1% to 30%) with respect to the exposure light (for example, the ArF excimer laser light), and a composition of film materials or film formation conditions of the film are adjusted to have the refractive index n and the extinction coefficient k.

### [Light shielding film]

The mask blank 100 in the present embodiment includes the light shielding film 3 as a thin film for forming a transfer pattern. The light shielding film 3 is a film that configures a light shielding film pattern including a light shielding band pattern formed on the mask blank 100, and is a film having a light shielding property with respect to the exposure light used in the exposure step in lithography. The light shielding film 3 has a multi-layer structure with the phase shift film 2, and an optical density (OD) with respect to the ArF excimer laser light having a wavelength of, for example, 193 nm is required to be more than 2.0, is preferably 2.8 or more, and more preferably 3.0 or more. In addition, in the exposure step in lithography, a surface reflectivity of the exposure light on both side main surfaces is suppressed to be low in order to prevent a defect of exposure transfer due to reflection of the exposure light. Particularly, a reflectivity of a front surface side of the light shielding film 3 (a surface on a farthest side from the translucent substrate 1) to which reflected light of the exposure light from an optical reduction system of an exposure apparatus strikes is desirably, for example, 40% or less (preferably 30% or less). This is to suppress a stray light generated by multiple reflection between the surface of the light shielding film 3 and a lens of the optical reduction system.

In addition, it is necessary that the light shielding film 3 functions as an etching mask when performing dry etching with a fluorine-based gas for forming a transfer pattern (a phase shift film pattern) on the phase shift film 2. Therefore, it is necessary to apply a material having sufficient etching selectivity to the phase shift film 2 to the light shielding film 3 in the dry etching with a fluorine-based gas. The light shielding film 3 is required to be capable of accurately forming a nanofabrication pattern to be formed on the phase shift film 2. A film thickness of the light shielding film 3 is preferably 70 nm or less, more preferably 65 nm or less, and particularly preferably 60 nm or less. When the film thickness of the light shielding film 3 is excessively thick, the nanofabrication pattern to be formed can be formed with a high accuracy. Meanwhile, the light shielding film 3 is required to satisfy the optical density required as described above. Therefore, the film thickness of the light shielding film 3 is required to be more than 15 nm, preferably 20 nm or more, and more preferably 25 nm or more.

The light shielding film 3 is formed of a material containing chromium. The material containing chromium may be a chromium simple substance or a material containing chromium and an additive element. As such an additive element, oxygen and/or nitrogen are preferable in that a dry etching rate can be increased. The light shielding film 3 may contain other elements such as carbon, hydrogen, boron, indium, tin, and molybdenum.

The light shielding film 3 can be formed by forming a film on the phase shift film 2 by a reactive sputtering method using a target containing chromium. The sputtering method may be a sputtering method using a direct current (DC) power supply (DC sputtering) or a sputtering method using a radiofrequency (RF) power supply (RF sputtering). In addition, the sputtering method may be a magnetron sputtering method or a conventional method. The DC sputtering is preferable in terms of a simple mechanism. In addition, it is preferable to use the magnetron sputtering method because a film formation rate is faster and a productivity is improved. A film forming apparatus may be an in-line type or a sheet type.

The material of the target may not be only a chromium simple substance, and may include any material as long as chromium is a main component, and chromium containing any one of oxygen and carbon or a target in which a combination of oxygen and carbon is added to chromium may be used.

### [Hard mask film]

The hard mask film 4 is provided on the light shielding film 3. The hard mask film 4 is a film formed of a material having an etching resistance with respect to an etching gas used when etching the light shielding film 3. A thickness of the hard mask film 4 is sufficient as long as the hard mask film 4 can function as an etching mask until dry etching for forming a pattern on the light shielding film 3 is completed, and basically, it is not limited in terms of optical characteristics. Therefore, the thickness of the hard mask film 4 can be significantly reduced compared to a thickness of the light shielding film 3.

The thickness of the hard mask film 4 is preferably 14 nm or less, and more preferably 10 nm or less. This is because, when the thickness of the hard mask film 4 is excessively thick, a thickness of a resist film which serves as an etching mask is required in the dry etching for forming a light shielding film pattern on the hard mask film 4. The thickness of the hard mask film 4 is preferably 4 nm or more, and more preferably 5 nm or more. This is because, when the thickness of the hard mask film 4 is excessively thin, there is a risk that the pattern of the hard mask film 4 disappears before the dry etching for forming the light shielding film pattern on the light shielding film 3 is completed, depending on conditions of the dry etching with an oxygen-containing chlorine-based gas.

A thickness of a resist film of an organic material used as an etching mask in the dry etching with a fluorine-based gas for forming the pattern on the hard mask film 4 is sufficient as long as the resist film can function as the etching mask until the dry etching of the hard mask film 4 is completed. Therefore, the thickness of the resist film can be significantly reduced by providing the hard mask film 4, compared to a configuration of the related art in which the hard mask film 4 is not provided.

The hard mask film 4 includes a multi-layer structure of a lower layer 41 and an upper layer 42. Here, the lower layer 41 is a layer positioned on a side of the light shielding film 3 side, of the hard mask film 4 configured with a plurality of layers. In addition, the upper layer 42 is, for example, a layer configuring an outermost layer of the hard mask film 4.

The lower layer 41 is preferably formed of a material containing at least one selected from tungsten, tellurium, ruthenium, and a compound thereof. As a material containing tungsten, WO_{X} or the like is preferably applied. In addition, as a material containing tellurium, TeO or the like is preferably applied. In addition, as a material containing ruthenium, a Ru simple substance or the like is preferably applied. Here, the "compound" described above refers to a compound containing at least one selected from oxygen, nitrogen, and carbon.

The lower layer 41 is preferably formed of a material in which a total content of the material containing at least one selected from tungsten, tellurium, ruthenium, and a compound thereof is 96 at% or more. Accordingly, a content of other elements can be suppressed to less than 4 at%, and an excellent etching rate can be ensured.

A thickness of the lower layer 41 of the hard mask film 4 is preferably 1 nm or more and 13 nm or less, more preferably 4 nm or more and 12 nm or less, and even more preferably 5 nm or more and 8 nm or less, in order to ensure uniformity of an in-plane distribution of the thickness of the lower layer 41. A ratio of the thickness (Dd) of the lower layer 41 to a thickness (Dt) of the entire hard mask film 4 (hereinafter, this may be referred to as a Du/Dd ratio) is preferably 0.3 or more, more preferably 0.5 or more, and even more preferably 0.7 or more. With the hard mask film 4 having such a configuration, it is possible to maintain high conductivity of the entire hard mask film 4.

In the present embodiment, a lower limit value of the thickness of the lower layer 41 is set to "1 nm" because the value is a film formation limit.

In addition, the upper layer 42 is preferably formed of tantalum (a tantalum simple substance) or a material containing a tantalum compound. Examples of the material containing tantalum in this case include a material containing one or more elements selected from tantalum, oxygen, nitrogen, and carbon. Examples thereof include TaO, TaN, TaC, TaON, TaCO, TaCN, and the like. In addition, from a viewpoint of suppressing a change over time in a degree of oxidation that occurs after the upper layer 42 is formed or the like, the upper layer 42 is preferably a material having a content of oxygen of 30 at% or more, more preferably 40 at% or more, and even more preferably 50 at% or more. Meanwhile, the content of oxygen in the upper layer 42 is preferably 71.4% or less. In a case where the upper layer 42 contains more oxygen than Ta₂O₅ which is stoichiometrically stable, there is a risk that a surface roughness of the film becomes rough.

In addition, the upper layer 42 is preferably formed of a material in which a total content of tantalum or a tantalum compound is 90 at% or more. Accordingly, a content of other elements can be suppressed to less than 10 at%, and excellent adhesion with the resist film, an excellent in-plane uniformity of critical dimension (CD), and CD linearity can be ensured.

A thickness of the upper layer 42 of the hard mask film 4 is preferably 1 nm or more, and more preferably 2 nm or more, in order to ensure uniformity of an in-plane distribution of the thickness of the upper layer 42. In addition, the thickness of the upper layer 42 of the hard mask film 4 is preferably 10 nm or less, and more preferably 8 nm or less. A ratio of the thickness (Du) of the upper layer 42 to the thickness (Dt) of the entire hard mask film 4 (hereinafter, this may be referred to as a Du/Dt ratio) is preferably 0.7 or less, more preferably 0.5 or less, and even more preferably 0.3 or less. With the hard mask film 4 having such a configuration, it is possible to suppress a decrease in the etching rate with respect to the fluorine-based gas in the entire hard mask film 4.

The hard mask film 4 may include an intermediate layer consisting of a material capable of being patterned by the dry etching with the fluorine-based gas between the upper layer 42 and the lower layer 41. In addition, the hard mask film 4 may include a lowermost layer consisting of a material capable of being patterned by the dry etching with the fluorine-based gas between the lower layer 41 and the light shielding film 3. Furthermore, at least one of the upper layer 42 and the lower layer 41 may have a structure in which a composition is inclined in a thickness direction.

As described above, by forming the lower layer 41 with a material containing at least one selected from tungsten, tellurium, ruthenium, and a compound thereof (an oxide, nitride, or carbide), conductivity of the hard mask film 4 can be increased compared to the hard mask film 4 according to the technology of the related art. As a result, charge (charge-up) of the resist film during electron beam drawing is suppressed as long as the hard mask film 4 according to the present embodiment is provided, compared to a case where the hard mask film 4 according to the technology of the related art is used (for example, the hard mask film 4 with a single layer configured with only tantalum). As a result, electrons from an electron beam drawing machine are emitted to an assumed point, and it is possible to improve a position accuracy of a drawing pattern, and to manufacture a phase shift mask having excellent pattern accuracy of each of a light shielding film pattern and a phase shift film pattern which will be described later.

In addition, by forming the lower layer 41 with the conductive material described above, the etching rate with the fluorine-based gas can be increased (become faster), and an effect of decreasing the resist film thickness can be obtained, compared to a case of using the hard mask film 4 according to the technology of the related art (for example, the hard mask film 4 with a single layer configured only with tantalum). As described above, when the hard mask film 4 according to the present embodiment capable of decreasing the resist film thickness is provided, further improvement of resolution can be expected.

In addition, by forming the upper layer 42 with a tantalum or a material containing a tantalum compound that has excellent adhesion with the resist film, peeling and the like of the resist film is reduced, and further improvement of the resolution of the resist film can be expected.

As described above, in the present embodiment, by forming the lower layer 41 with the material having a high conductivity described above, it is possible to suppress the occurrence of charge itself of the resist film at the time of electron beam drawing, and it is possible to increase an improvement amount of the position accuracy, compared to a correction technology of the electron beam drawing machine according to the technology of the related art.

In addition, in the charge suppression technology using a CDL described above, it is necessary to consider a compatibility (an affinity or combination) between the resist film and the CDL. However, in the present embodiment, since the lower layer 41 is formed of the material having a high conductivity described above and the upper layer 42 is formed of the tantalum-containing material having a high affinity with the resist film, it is possible to suppress the occurrence of charge of the resist film without considering the compatibility (the affinity or combination) between the lower layer 41 and the resist film, and increase versatility.

### [Resist film]

In the mask blank 100, it is preferable that a resist film of an organic material is formed to have a film thickness of 100 nm or less in contact with a surface of the hard mask film 4. In a case of nanofabrication pattern corresponding to a DRAM hp32nm generation, a sub-resolution assist feature (SRAF) having a line width of 40 nm may be provided on a light shielding film pattern to be formed on the light shielding film 3. However, even in this case, the film thickness of the resist film can be suppressed by providing the hard mask film 4 as described above, and accordingly, a cross-sectional aspect ratio of a resist pattern configured with the resist film can be decreased to 1:2.5. Therefore, it is possible to suppress the resist pattern from collapsing or detaching during development, rinsing, or the like of the resist film. The film thickness of the resist film is more preferably 80 nm or less. The resist film is preferably a resist for electron beam drawing exposure, and more preferably a chemical amplification type resist.

### [Manufacturing procedure of mask blank]

The mask blank 100 having the configuration described above can be manufactured, for example, by the following procedure. First, the translucent substrate 1 is prepared. The translucent substrate 1 is formed by polishing an end surface and a main surface to have a predetermined surface roughness (for example, in an inner region of a square having one side of 1 µm, a square mean square root roughness Rq is 0.2 nm or less), and then, performing predetermined cleaning treatment and drying treatment.

Next, the phase shift film 2 is formed on the translucent substrate 1 by a sputtering method. After the phase shift film 2 is formed, an annealing treatment is performed at a predetermined heating temperature. Next, the light shielding film 3 is formed on the phase shift film 2 by the sputtering method. The hard mask film 4 including the upper layer 42 and the lower layer 41 is formed on the light shielding film 3 by the sputtering method. In the film formation of each layer by the sputtering method, the film formation is performed by using a sputtering target and a sputtering gas containing materials configuring each layer at a predetermined composition ratio, and if necessary, using a mixed gas of noble gas and a reactive gas described above as the sputtering gas. A resist film is formed on the surface of the hard mask film 4 by a coating method such as a spin coating method or the like to complete the mask blank 100.

### <Method for manufacturing phase shift mask>

Next, a method for manufacturing the phase shift mask (a photomask) of the present embodiment will be described using a method for manufacturing a halftone type phase shift mask using the mask blank 100 having the configuration illustrated in FIG. 1 as an example.

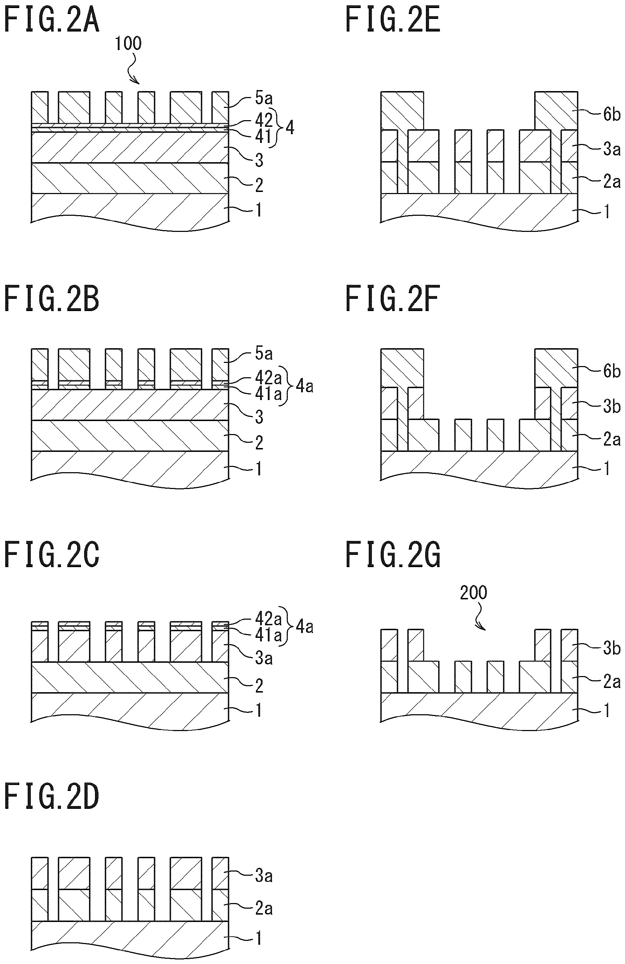

First, a resist film is formed on the hard mask film 4 of the mask blank 100 by the spin coating method. Next, a first pattern (a phase shift film pattern) to be formed on the phase shift film 2 is exposed to and drawn on the resist film with electron beams. After that, a resist pattern 5a is formed on the hard mask film 4 of the mask blank 100 by performing predetermined treatments such as a PEB treatment, a development treatment, a post-bake treatment, and the like with respect to the resist film (see FIG. 2A).

Next, the dry etching of the hard mask film 4 is performed with the fluorine-based gas using the resist pattern 5a as a mask, and a hard mask pattern 4a including an upper layer pattern 42a and a lower layer pattern 41a is formed (see FIG. 2B). After this, the resist pattern 5a is removed. Here, the dry etching of the light shielding film 3 may be performed while the resist pattern 5a is not removed and remains. In this case, the resist pattern 5a disappears during the dry etching of the light shielding film 3.

Next, the dry etching is performed with a mixed gas of chlorine and oxygen using the hard mask pattern 4a as a mask, and a light shielding film pattern 3a which is a thin film pattern formed on the light shielding film 3 which is a thin film for forming a pattern (see FIG. 2C).

Subsequently, the dry etching using the fluorine-based gas is performed using the light shielding film pattern 3a as a mask, and the hard mask pattern 4a is removed while forming the phase shift film pattern 2a on the phase shift film 2 (see FIG. 2D).

Next, the resist film is formed on the light shielding film pattern 3a by the spin coating method. The light shielding film pattern to be formed on the light shielding film 3 is exposed to and drawn on the resist film with electron beams. After this, a predetermined treatment such as a development treatment or the like is performed to form a resist film having a resist pattern 6b (see FIG. 2E).

Next, the dry etching using a mixed gas of a chlorine-based gas and an oxygen gas is performed using the resist pattern 6b as a mask, and the light shielding film pattern 3b is formed on the light shielding film 3 (see FIG. 2F). In addition, the resist pattern 6b is removed, and a predetermined treatment such as cleaning or the like is performed to obtain a phase shift mask 200 (see FIG. 2G).

The chlorine-based gas used in the dry etching during the manufacturing step described above is not particularly limited as long as it contains Cl. Examples of the chlorine-based gas include Cl₂, SiCl₂, CHCl₃, CH₂Cl₂, CCl₄, BCl₃, and the like. In addition, the fluorine-based gas used in the dry etching during the manufacturing step described above is not particularly limited as long as it contains F. Examples of the fluorine-based gas include CHF₃, CF₄, C₂F₆, C₄F₈, SF₆, and the like. Particularly, since the fluorine-based gas that does not contain C has a relatively low etching rate with respect to a glass substrate, a damage to the glass substrate can be further reduced.

The phase shift mask 200 manufactured by the step described above has a configuration in which the phase shift film pattern 2a and the light shielding film pattern 3b are deposited on the translucent substrate 1 in this order from a side of the translucent substrate 1.

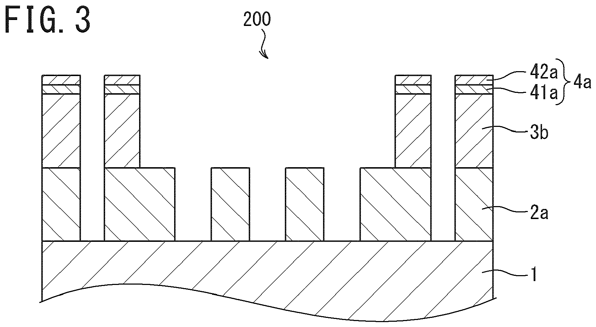

In the phase shift mask 200 manufactured by the step described above, the hard mask film 4 deposited on the light shielding film pattern 3a is removed, however as illustrated in FIG. 3, the hard mask film 4 deposited on the light shielding film pattern 3a (the light shielding film pattern 3b) may remain as it is. That is, as illustrated in FIG. 3, the hard mask film 4 (the hard mask pattern 4a) is formed only on the light shielding film pattern 3b (only on an outer peripheral light shielding frame portion), and is not formed in a so-called main pattern (a transfer pattern) in which only the phase shift film pattern 2a is formed.

Hereinabove, in the method for manufacturing the phase shift mask described above, the phase shift mask 200 is manufactured using the mask blank 100 described above with reference to FIG. 1. The mask blank 100 used in the manufacturing of such a phase shift mask has a characteristic configuration in which the hard mask film 4 has a multi-layer structure of the lower layer 41 and the upper layer 42, the lower layer 41 is formed of a material containing at least one selected from tungsten, tellurium, ruthenium, and a compound thereof (for example, an oxide, nitride, or carbide), and the upper layer 42 is formed of a material containing tantalum or a tantalum compound (for example, an oxide, nitride, or carbide). Accordingly, the phase shift mask 200 can be manufactured by suppressing the charge of the resist film at the time of electron beam drawing. As a result of the above operation, the phase shift mask 200 having an excellent pattern accuracy can be manufactured.

In the present embodiment, the mask blank for manufacturing the phase shift mask 200 has been described as a transfer mask, however, the present invention is not limited thereto, and for example, the present invention can also be applied to a mask blank for manufacturing a binary mask or a digging type Levenson type phase shift mask.

### [Examples]

Hereinafter, an embodiment of the present invention will be described in more detail with reference to examples.

### <Example 1>

### [Manufacturing of mask blank]

With reference to FIG. 1, the translucent substrate 1 consisting of a synthetic quartz glass having a dimension of a main surface of about 152 mm x about 152 mm and a thickness of about 6.35 mm was prepared. An end surface and a main surface of the translucent substrate 1 are polished to have a predetermined surface roughness (0.2 nm or less in terms of Rq), and then a predetermined cleaning treatment and drying treatment are performed.

Next, using a DC sputtering apparatus using two targets, the phase shift film 2 consisting of silicon, molybdenum, oxygen, and nitrogen was formed on the translucent substrate 1 to have a thickness of 75 nm. Molybdenum and silicon were used as the targets, and argon, oxygen, and nitrogen were used as the sputtering gas. When the composition of the phase shift film was analyzed by ESCA, a composition ratio was Si:Mo:O:N = 42:7:5:46 (at% ratio).

In the phase shift film 2 formed as described above, a transmittance of exposure light was 6%, and a phase difference was 177 degrees. In Example 1 and each of examples and comparative examples which will be described later, the transmittance and the phase difference were measured using a phase shift amount measurement apparatus (manufactured by Lasertec Corporation, MPM193: measurement wavelength of 193 nm). A transmittance and a phase difference of each of examples and comparative examples hereinafter were also measured in the same manner.

In addition, in the present examples, the "transmittance of the exposure light" refers to a transmittance of an exposure light of a non-opening portion with respect to an opening portion of the phase shift film 2. Further, the "phase difference" refers to a phase difference of the non-opening portion with respect to the opening portion of the phase shift film 2.

Next, using the DC sputtering apparatus, the light shielding film 3 consisting of chromium, oxygen, and nitrogen was formed on the phase shift film 2 to have a thickness of 30 nm. Chromium was used as the target, and argon, oxygen, and nitrogen were used as the sputtering gas. When a composition of the light shielding film 3 was analyzed by ESCA, a composition ratio was Cr:O:N = 50:30:20 (at% ratio).

Next, the translucent substrate 1 on which the light shielding film 3 was formed was subjected to a heat treatment. Specifically, the heat treatment was performed in an atmosphere using a hot plate at a heating temperature of 280°C for a heating time of 5 minutes. After the heat treatment, for the translucent substrate 1 on which the phase shift film 2 and the light shielding film 3 are deposited, when an optical density (OD) at a wavelength (about 193 nm) of light of ArF excimer laser having a multi-layer structure of the phase shift film 2 and the light shielding film 3 was measured using a spectrophotometer (Cary 4000 manufactured by Agilent Technologies, Inc.), the optical density was confirmed to be 3.0.

Next, using the DC sputtering apparatus, the lower layer 41 of the hard mask film 4 consisting of tungsten and oxygen was formed on the light shielding film 3 to have a thickness of 3 nm. Tungsten oxide (WOx) was used as the target, and argon and oxygen were used as the sputtering gas. When a composition of the lower layer 41 of the hard mask film 4 was analyzed by ESCA, a composition ratio was W:O = 25:75 (at% ratio).

Next, using the DC sputtering apparatus, the upper layer 42 of the hard mask film 4 consisting of tantalum and oxygen was formed on the lower layer 41 of the hard mask film 4 to have a thickness of 2 nm. Tantalum oxide (TaO) was used as the target, and argon and oxygen were used as the sputtering gas. When a composition of the upper layer 42 of the hard mask film 4 was analyzed by ESCA, a composition ratio was Ta:O = 35:65 (at% ratio).

As described above, the hard mask film 4 including the lower layer 41 and the upper layer 42 was formed on the light shielding film 3 to have a thickness of 5 nm.

Finally, the mask blank 100 of Example 1 was manufactured by performing a predetermined cleaning treatment.

### (Measurement of electrical resistivity)

Next, for the mask blank 100, an electrical resistivity (Q-m) with respect to a conductivity of the hard mask film 4 including the lower layer 41 and the upper layer 42 was measured and was 5.29 x 10⁻⁸.

The smaller the value of the electrical resistivity, the higher the conductivity of the hard mask film 4. Therefore, in a case of the hard mask film 4 having a small value of the electrical resistivity, it is possible to improve the position accuracy of electron beam irradiation by suppressing charge of the resist film at the time of the electron beam drawing, that is, it is possible to form a nanofabrication resist pattern on the resist film with high accuracy.

When the value of the electrical resistivity (Ω·m) of the hard mask film 4 is 1.00 x 10⁻⁷ or less, the conductivity is extremely high and it can be said that it is the hard mask film 4 (the mask blank 100) substantially not affected by the charge of the hard mask film 4 at the time of electron beam drawing. In addition, when the value of the electrical resistivity (Ω·m) of the hard mask film 4 is 1.00 x 10⁻⁵ or less, the conductivity is high and it can be said that it is the hard mask film 4 (the mask blank 100) extremely slightly affected by the charge of the hard mask film 4 at the time of electron beam drawing. Furthermore, when the value of the electrical resistivity (Ω·m) of the hard mask film 4 is 1.00 × 10⁻³ or less, the conductivity is sufficient and it can be said that it is the hard mask film 4 (the mask blank 100) slightly affected by the charge of the hard mask film 4 at the time of electron beam drawing. On the other hand, when the value of the electrical resistivity (Ω·m) of the hard mask film 4 exceeds 1.00 × 10⁻³, the conductivity is insufficient and it can be said that it is the hard mask film 4 (the mask blank 100) easily affected by the charge of the hard mask film 4 at the time of electron beam drawing.

From results of the measurement described above, it was confirmed that, in a case of the mask blank 100 of Example 1, since the electrical resistivity (Ω·m) of the hard mask film 4 is 5.29 x 10⁻⁸, the hard mask film 4 was hardly affected by the charge of the hard mask film 4 at the time of electron beam drawing.

In Table 1 below, when the value of the electrical resistivity (Ω·m) of the hard mask film 4 was 1.00 x 10⁻⁷ or less, it was evaluated as "⊚", when the value thereof was 1.00 × 10⁻⁵ or less, it was evaluated as "o", when the value thereof was 1.00 × 10⁻³ or less, it was evaluated as "Δ", and when the value thereof exceeded 1.00 × 10⁻³, it was evaluated as "x". In the present examples, "⊚", "∘", and "Δ" were acceptable.

In the present examples, the electrical resistivity (Ω·m) was measured at each of 10 points on the surface of the hard mask film 4 using a commercially available electrical resistivity measurement apparatus, and an average value thereof was set as the "electrical resistivity (Ω·m)".

### [Manufacturing of phase shift mask]

Next, the halftone type phase shift mask 200 of Example 1 was manufactured using the mask blank 100 of Example 1 described above in the following procedure.

First, a resist film consisting of a chemical amplification type resist for electron beam drawing was formed in contact with the surface of the hard mask film 4 to have a film thickness of 129 nm by the spin coating method.

Next, a first pattern which is a phase shift film pattern to be formed on the phase shift film 2 was drawn on the resist film with electron beams, predetermined development treatment and cleaning treatment were performed, and the resist pattern 5a having the first pattern was formed (see FIG. 2A). It was assumed that the first pattern has a line-and-space pattern having a line width of 200 nm and a pattern having an extremely small size (a line width of 30 nm). More specifically, a negative type chemical amplification type electron beam resist was spin-coated on the hard mask film 4 to have a film thickness of 129 nm, and a pattern was drawn with electron beams at a dosage of 35 µC/cm², was heated at 110°C for 10 minutes, and was developed by puddle development for 90 seconds to form the resist pattern 5a.

Next, the dry etching using a mixed gas of a CF₄ gas and an oxygen gas (O₂) was performed using the resist pattern 5a as a mask, and the hard mask pattern 4a including the upper layer pattern 42a and the lower layer pattern 41a was formed on the hard mask film 4 including the upper layer 42 and the lower layer 41 (see FIG. 2B). A gas pressure of an etching gas was set to 5 mTorr, an ICP power was set to 400 W, and a bias power was set to 40 W.

The resist pattern 5a after forming the hard mask pattern 4a remained with a sufficient film thickness. In addition, it could be confirmed that all patterns including a pattern having the extremely small size included in the resist pattern 5a were formed on the hard mask film 4 with a high accuracy by measurement (observation) using a critical dimension-scanning electron microscope (CD-SEM).

### (Measurement of etching rate)

Here, regarding etching processability of the hard mask film 4 of Example 1, an etching rate ratio of the hard mask film 4 of Example 1 (an etching rate of the hard mask film 4 of Example 1/an etching rate of the hard mask film 4 of Comparative Example 1) was measured, and it was 2.1.

A value of the etching rate ratio is great, it implies that the etching processability is high, compared to the hard mask film 4 of Comparative Example 1 according to the technology of the related art (that is, the hard mask film 4 used in general). In a case of the hard mask film 4 having a high etching rate ratio, the etching processability is excellent, and it is possible to make the resist film thinner, that is, improve the resolution.

When the etching rate ratio of the hard mask film 4 is 1.5 or more, the etching processability is extremely high and it can be said that it is the hard mask film 4 (the mask blank 100) capable of sufficiently making the resist film thin. In addition, when the etching rate ratio of the hard mask film 4 is 1.3 or more, the etching processability is high and it can be said that it is the hard mask film 4 (the mask blank 100) capable of making the resist film thin. Furthermore, when the etching rate ratio of the hard mask film 4 exceeds 1.0, the etching processability is sufficient and it can be said that it is the hard mask film 4 (the mask blank 100) capable of making the resist film thin. Furthermore, when the etching rate ratio of the hard mask film 4 is 1.0 or less, the etching processability is insufficient and it can be said that it is the hard mask film 4 (the mask blank 100) which hardly makes the resist film thin.

From results of the measurement described above, in a case of the mask blank 100 of Example 1, since the etching rate ratio of the hard mask film 4 is 2.1, it was confirmed that the etching processability of the hard mask film 4 is extremely high and the resist film could be sufficiently made thin.

In Table 1 below, when the etching rate ratio of the hard mask film 4 was 1.5 or more, it was evaluated as "⊚ ", when the etching rate ratio was 1.3 or more, it was evaluated as "o", when the etching rate ratio exceeded 1.0, it was evaluated as "Δ", and when the etching rate ratio is 1.0 or less, it was evaluated as "x". In the present examples, "⊚", "o", and "Δ" were acceptable.

In the present examples, 10 samples of the mask blank 100 manufactured in the same step were prepared, and an etching depth with respect to an etching time was measured. An average value of each etching rate of the 10 samples thus obtained was defined as an "etching rate". The etching rate ratio of the hard mask film 4 of Example 1 was obtained by calculating the etching rate of the hard mask film 4 of Example 1 to the etching rate of the hard mask film 4 of Comparative Example 1.

Next, the resist pattern 5a was removed by peeling and cleaning by sulfuric acid-hydrogen peroxide mixture cleaning.

Subsequently, the dry etching using a mixed gas of a chlorine gas (Cl₂), an oxygen gas (O₂), and helium (He) was performed using the hard mask pattern 4a as a mask, and the light shielding film pattern 3a was formed on the light shielding film 3 (see FIG. 2C). A gas pressure of an etching gas was set to 5 mTorr, an ICP power was set to 400 W, and a bias power was set to 40 W. Overetching was performed by 100%.

Next, the dry etching using a mixed gas of a CF₄ gas and an oxygen gas (O₂) was performed using the light shielding film pattern 3a as a mask, the phase shift film pattern 2a which is the first pattern was formed on the phase shift film 2, and the hard mask pattern 4a was removed at the same time (see FIG. 2D). A gas pressure of an etching gas was set to 5 mTorr, an ICP power was set to 400 W, and a bias power was set to 40 W. When a quartz substrate was dug by 3 nm on average, the dry etching was stopped.

Next, a resist film consisting of a chemical amplification type resist for electron beam drawing was formed on the light shielding film pattern 3a to have a film thickness of 150 nm by the spin coating method.

Next, a second pattern which is a pattern (a pattern having a light shielding band pattern) to be formed on the light shielding film was exposed to and drawn on the resist film, a predetermined treatment such as a development treatment was performed, and the resist pattern 6b having a light shielding film pattern was formed (see FIG. 2E).

Subsequently, the dry etching using a mixed gas of a chlorine gas (Cl₂), an oxygen gas (O₂), and helium (He) was performed using the resist pattern 6b as a mask, and the light shielding film pattern 3b was formed on the light shielding film 3 (see FIG. 2F). A gas pressure of an etching gas was set to 10 mTorr, an ICP power was set to 500 W, and a bias power was set to 10 W. Overetching was performed by 200%. At this time, no damage occurred to the phase shift film 2 (the phase shift film pattern 2a) and the translucent substrate 1 which are lower layers.

Next, the resist pattern 6b was removed by peeling and cleaning by sulfuric acid-hydrogen peroxide mixture cleaning.

Finally, a predetermined treatment such as cleaning or the like was performed to obtain the phase shift mask 200 (see FIG. 2G).

In the phase shift mask 200 of Example 1 manufactured by obtaining the above procedure, it could be confirmed that all patterns including a pattern having the extremely small size included in the resist pattern 5a were formed on the phase shift film 2 with a high accuracy by measurement (observation) using CD-SEM. In addition, with respect to the phase shift mask 200 of Example 1, a simulation of a transfer image when exposed and transferred to the resist film on a semiconductor device with an exposure light having a wavelength of 193 nm was performed using AIMS193 (manufactured by Carl Zeiss). When an exposure transfer image of this simulation was verified, design specifications were sufficiently satisfied.

### <Example 2>

### [Manufacturing of mask blank]

A mask blank of Example 2 was manufactured in the same procedure as in Example 1 except for the hard mask film 4. Therefore, here, only the manufacturing step of the hard mask film 4 according to Example 2 will be described.

Using the DC sputtering apparatus, the lower layer 41 of the hard mask film 4 consisting of tellurium and oxygen was formed on the light shielding film 3 manufactured in the same procedure as in Example 1 to have a thickness of 3 nm. Tellurium oxide (TeO) was used as the target, and argon and oxygen were used as the sputtering gas. When a composition of the lower layer 41 of the hard mask film 4 was analyzed by ESCA, a composition ratio was Te:O = 35:65 (at% ratio).

Next, using the DC sputtering apparatus, the upper layer 42 of the hard mask film 4 consisting of tantalum and nitrogen was formed on the lower layer 41 of the hard mask film 4 to have a thickness of 2 nm. Tantalum nitride (TaN) was used as the target, and argon and oxygen were used as the sputtering gas. When a composition of the upper layer 42 of the hard mask film 4 was analyzed by ESCA, a composition ratio was Ta:N = 20:80 (at% ratio).

As described above, the hard mask film 4 including the lower layer 41 and the upper layer 42 was formed on the light shielding film 3 to have a thickness of 5 nm.

Finally, the mask blank 100 of Example 2 was manufactured by performing a predetermined cleaning treatment in the same manner as in a case of Example 1.

### (Measurement of electrical resistivity)

Next, for the mask blank 100, an electrical resistivity (Ω·m) with respect to a conductivity of the hard mask film 4 including the lower layer 41 and the upper layer 42 was measured and was 1.00 × 10⁻⁴.

From results of the measurement described above, it was confirmed that, in a case of the mask blank 100 of Example 2, since the electrical resistivity (Ω·m) of the hard mask film 4 is 1.00 × 10⁻⁴, the hard mask film 4 was extremely slightly affected by the charge of the hard mask film 4 at the time of electron beam drawing.

In the phase shift film 2 of Example 2, a transmittance of exposure light was 6%, and a phase difference was 177 degrees. In addition, in Example 2, the optical density (OD) of the translucent substrate 1 on which the phase shift film 2 and the light shielding film 3 were deposited was 3.0.

### [Manufacturing of phase shift mask]

Next, the phase shift mask 200 of Example 2 was manufactured using the mask blank 100 of Example 2 in the same procedure as in Example 1. A film thickness of the resist film consisting of the chemical amplification type resist for electron beam drawing was set to 135 nm. In addition, the resist pattern 5a after forming the hard mask pattern 4a remained with a sufficient film thickness. Furthermore, it could be confirmed that all patterns including a pattern having the extremely small size included in the resist pattern 5a were formed on the hard mask film 4 with a high accuracy by measurement (observation) using CD-SEM.

In addition, in the manufactured phase shift mask 200 of Example 2, it could be confirmed that all patterns including a pattern having the extremely small size included in the resist pattern 5a were formed on the phase shift film 2 with a high accuracy by measurement (observation) using CD-SEM.

In addition, with respect to the phase shift mask 200 of Example 2, a simulation of a transfer image when exposed and transferred to the resist film on a semiconductor device with an exposure light having a wavelength of 193 nm was performed using AIMS193 (manufactured by Carl Zeiss). When an exposure transfer image of this simulation was verified, design specifications were sufficiently satisfied.

### (Measurement of etching rate)

In addition, regarding etching processability of the hard mask film 4 of Example 2, an etching rate ratio of the hard mask film 4 of Example 2 (an etching rate of the hard mask film 4 of Example 2/an etching rate of the hard mask film 4 of Comparative Example 1) was measured, and it was 1.7.

From results of the measurement described above, in a case of the mask blank 100 of Example 2, since the etching rate ratio of the hard mask film 4 is 1.7, it was confirmed that the etching processability of the hard mask film 4 is extremely high and the resist film could be sufficiently made thin.

### <Example 3>

### [Manufacturing of mask blank]

A mask blank of Example 3 was manufactured in the same procedure as in Example 1 except for the hard mask film 4. Therefore, here, only the manufacturing step of the hard mask film 4 according to Example 3 will be described.

Using the DC sputtering apparatus, the lower layer 41 of the hard mask film 4 consisting of ruthenium was formed on the light shielding film 3 manufactured in the same procedure as in Example 1 to have a thickness of 3 nm. Ruthenium (Ru) was used as the target, and argon, oxygen, and nitrogen were used as the sputtering gas. When a composition of the lower layer 41 of the hard mask film 4 was analyzed by ESCA, a composition ratio was Ru = 100 (at% ratio).

Next, using the DC sputtering apparatus, the upper layer 42 of the hard mask film 4 consisting of tantalum was formed on the lower layer 41 of the hard mask film 4 to have a thickness of 2 nm. Tantalum (Ta) was used as the target, and argon and oxygen were used as the sputtering gas. When a composition of the upper layer 42 of the hard mask film 4 was analyzed by ESCA, a composition ratio was Ta = 100 (at% ratio).

As described above, the hard mask film 4 including the lower layer 41 and the upper layer 42 was formed on the light shielding film 3 to have a thickness of 5 nm.

Finally, the mask blank 100 of Example 3 was manufactured by performing a predetermined cleaning treatment in the same manner as in a case of Example 1.

### (Measurement of electrical resistivity)

Next, for the mask blank 100, an electrical resistivity (Ω·m) with respect to a conductivity of the hard mask film 4 including the lower layer 41 and the upper layer 42 was measured and was 7.10 x 10⁻⁸.

From results of the measurement described above, it was confirmed that, in a case of the mask blank 100 of Example 3, since the electrical resistivity (Ω·m) of the hard mask film 4 is 7.10 x 10⁻⁸, the hard mask film 4 was hardly affected by the charge of the hard mask film 4 at the time of electron beam drawing.

In the phase shift film 2 of Example 3, a transmittance of exposure light was 6%, and a phase difference was 177 degrees. In addition, in Example 3, the optical density (OD) of the translucent substrate 1 on which the phase shift film 2 and the light shielding film 3 were deposited was 3.0.

### [Manufacturing of phase shift mask]

Next, the phase shift mask 200 of Example 3 was manufactured using the mask blank 100 of Example 3 in the same procedure as in Example 1. A film thickness of the resist film consisting of the chemical amplification type resist for electron beam drawing was set to 146 nm. In addition, the resist pattern 5a after forming the hard mask pattern 4a remained with a sufficient film thickness. Furthermore, it could be confirmed that all patterns including a pattern having the extremely small size included in the resist pattern 5a were formed on the hard mask film 4 with a high accuracy by measurement (observation) using CD-SEM.

In addition, in the manufactured phase shift mask 200 of Example 3, it could be confirmed that all patterns including a pattern having the extremely small size included in the resist pattern 5a were formed on the phase shift film 2 with a high accuracy by measurement (observation) using CD-SEM.

In addition, with respect to the phase shift mask 200 of Example 3, a simulation of a transfer image when exposed and transferred to the resist film on a semiconductor device with an exposure light having a wavelength of 193 nm was performed using AIMS193 (manufactured by Carl Zeiss). When an exposure transfer image of this simulation was verified, design specifications were sufficiently satisfied.

### (Measurement of etching rate)

In addition, regarding etching processability of the hard mask film 4 of Example 3, an etching rate ratio of the hard mask film 4 of Example 3 (an etching rate of the hard mask film 4 of Example 3/an etching rate of the hard mask film 4 of Comparative Example 1) was measured, and it was 1.3.

From results of the measurement described above, in a case of the mask blank 100 of Example 3, since the etching rate ratio of the hard mask film 4 is 1.3, it was confirmed that the etching processability of the hard mask film 4 is high and the resist film could be made thin.

### <Comparative Example 1>

### [Manufacturing of mask blank]

A mask blank of Comparative Example 1 was manufactured in the same procedure as in Example 1 except for the hard mask film 4. Therefore, here, only the manufacturing step of the hard mask film 4 according to Comparative Example 1 will be described.

Using the DC sputtering apparatus, the hard mask film 4 consisting of tantalum and oxygen was formed on the light shielding film 3 manufactured in the same procedure as in Example 1 to have a thickness of 5 nm. Tantalum oxide (TaO) was used as the target, and argon and oxygen were used as the sputtering gas. When a composition of the hard mask film 4 was analyzed by ESCA, a composition ratio was Ta:O = 35:65 (at% ratio).

In other words, the hard mask film 4 provided in the mask blank of Comparative Example 1 is the single-layer hard mask film 4 configured with tantalum oxide (TaO).

Finally, the mask blank 100 of Comparative Example 1 was manufactured by performing a predetermined cleaning treatment in the same manner as in a case of Example 1.

### (Measurement of electrical resistivity)

Next, for the mask blank 100, an electrical resistivity (Ω·m) with respect to a conductivity of the hard mask film 4 was measured and was 1.50 × 10⁻⁷.

From results of the measurement described above, it was confirmed that, in a case of the mask blank 100 of Comparative Example 1, since the electrical resistivity (Ω·m) of the hard mask film 4 is 1.50 x 10⁻⁷, the hard mask film 4 was extremely slightly affected by the charge of the hard mask film 4 at the time of electron beam drawing.

In the phase shift film 2 of Comparative Example 1, a transmittance of exposure light was 6%, and a phase difference was 177 degrees. In addition, in Comparative Example 1, the optical density (OD) of the translucent substrate 1 on which the phase shift film 2 and the light shielding film 3 were deposited was 3.0.

### [Manufacturing of phase shift mask]

Next, the phase shift mask of Comparative Example 1 was manufactured using the mask blank of Comparative Example 1 in the same procedure as in Example 1. A film thickness of the resist film consisting of the chemical amplification type resist for electron beam drawing was set to 160 nm. In addition, the resist pattern 5a after forming the hard mask pattern 4a remained with a sufficient film thickness. On the other hand, the pattern having the extremely small size included in the resist pattern 5a could not be formed in the hard mask pattern 4a.

In addition, in the manufactured phase shift film pattern 2a of the phase shift mask 200 of Comparative Example 1, the pattern having the extremely small size could not be formed in the phase shift film pattern 2a.

In addition, with respect to the phase shift mask of Comparative Example 1, a simulation of a transfer image when exposed and transferred to the resist film on a semiconductor device with an exposure light having a wavelength of 193 nm was performed using AIMS193 (manufactured by Carl Zeiss) in the same manner as in Example 1. When an exposure transfer image of this simulation was verified, a transfer defect was confirmed. It is presumed that the transfer defect has occurred because the pattern having the extremely small size could not be formed.

### (Measurement of etching rate)

An etching rate of the hard mask film 4 of Comparative Example 1 was measured, and a value was used as a reference value for each etching rate ratio.

### <Comparative Example 2>

### [Manufacturing of mask blank]

A mask blank of Comparative Example 2 was manufactured in the same procedure as in Example 1 except for the hard mask film 4. Therefore, here, only the manufacturing step of the hard mask film 4 according to Comparative Example 2 will be described.

Using the DC sputtering apparatus, the lower layer 41 of the hard mask film 4 consisting of silicon was formed on the light shielding film 3 manufactured in the same procedure as in Example 1 to have a thickness of 3 nm. Silicon (Si) was used as the target, and argon and oxygen were used as the sputtering gas. When a composition of the lower layer 41 of the hard mask film 4 was analyzed by ESCA, a composition ratio was Si = 100 (at% ratio).

Next, using the DC sputtering apparatus, the upper layer 42 of the hard mask film 4 consisting of tantalum and oxygen was formed on the lower layer 41 of the hard mask film 4 to have a thickness of 2 nm. Tantalum oxide (TaO) was used as the target, and argon and oxygen were used as the sputtering gas. When a composition of the upper layer 42 of the hard mask film 4 was analyzed by ESCA, a composition ratio was Ta:O = 35:65 (at% ratio). As described above, the hard mask film 4 including the lower layer 41 and the upper layer 42 was formed on the light shielding film 3 to have a thickness of 5 nm.

Finally, the mask blank 100 of Comparative Example 2 was manufactured by performing a predetermined cleaning treatment in the same manner as in a case of Example 1.

### (Measurement of electrical resistivity)

Next, for the mask blank 100, an electrical resistivity (Ω·m) with respect to a conductivity of the hard mask film 4 was measured and was 3.97 × 10³.

From results of the measurement described above, it was confirmed that, in a case of the mask blank 100 of Comparative Example 2, since the electrical resistivity (Ω·m) of the hard mask film 4 is 3.97 x 103, the hard mask film 4 was easily affected by the charge of the hard mask film 4 at the time of electron beam drawing.

In the phase shift film 2 of Comparative Example 2, a transmittance of exposure light was 6%, and a phase difference was 177 degrees. In addition, in Comparative Example 2, the optical density (OD) of the translucent substrate 1 on which the phase shift film 2 and the light shielding film 3 were deposited was 3.0.

### [Manufacturing of phase shift mask]

Next, the phase shift mask of Comparative Example 2 was manufactured using the mask blank of Comparative Example 2 in the same procedure as in Example 1. A film thickness of the resist film consisting of the chemical amplification type resist for electron beam drawing was set to 126 nm. In addition, the resist pattern 5a after forming the hard mask pattern 4a remained with a sufficient film thickness. On the other hand, the pattern having the extremely small size included in the resist pattern 5a could not be formed in the hard mask pattern 4a.

In addition, in the manufactured phase shift film pattern 2a of the phase shift mask 200 of Comparative Example 2, the pattern having the extremely small size could not be formed in the phase shift film pattern 2a.

In addition, with respect to the phase shift mask of Comparative Example 2, a simulation of a transfer image when exposed and transferred to the resist film on a semiconductor device with an exposure light having a wavelength of 193 nm was performed using AIMS193 (manufactured by Carl Zeiss) in the same manner as in Example 1. When an exposure transfer image of this simulation was verified, a transfer defect was confirmed. It is presumed that the transfer defect has occurred because the pattern having the extremely small size could not be formed.

### (Measurement of etching rate)

In addition, regarding etching processability of the hard mask film 4 of Comparative Example 2, an etching rate ratio of the hard mask film 4 of Comparative Example 2 (an etching rate of the hard mask film 4 of Comparative Example 2/an etching rate of the hard mask film 4 of Comparative Example 1) was measured, and it was 2.3.

From results of the measurement described above, in a case of the mask blank 100 of Comparative Example 2, since the etching rate ratio of the hard mask film 4 is 2.3, it was confirmed that the etching processability of the hard mask film 4 is high and the resist film could be made thin.

The results described above are shown in Table 1.

**[Table 1]**

| | | Ex. 1 | | | | | Ex. 2 | | | | | Ex. 3 | | | | |
|---|---|---|---|---|---|---|---|---|---|---|---|---|---|---|---|---|
| Layer | | Phase shift film | Light shielding film | Hard mask film | | Resist film | Phase shift film | Light shielding film | Hard mask film | | Resist film | Phase shift film | Light shielding film | Hard mask film | | Resist film |
| | | | | Lower layer | Upper layer | | | | Lower layer | Upper layer | | | | Lower layer | Upper layer | |
| Composition | | MoSi | Cr | WOx | TaOx | - | MoSi | Cr | TeOx | TaNx | - | MoSi | Cr | Ru | Ta | - |
| Film thickness (nm) | | 75 | 30 | 3 | 2 | 129 | 75 | 30 | 3 | 2 | 135 | 75 | 30 | 3 | 2 | 146 |
| F-based etching processability | Etching rate ratio (to Comp. Ex. 1) | - | | 2.1 | | - | - | | 1.7 | | - | - | | 1.3 | | - |
| | Evaluation | - | | ⊚ | | - | - | | ⊚ | | - | - | | ○ | | - |
| Conductivity | Electrical resistivity (Ω·m) | - | | 5.29 × 10⁻⁸ | | - | - | | 1.00 × 10⁻⁴ | | - | - | | 7.10 × 10⁻⁸ | | - |
| | Evaluation | - | | ⊚ | | - | - | | Δ | | - | - | | ⊚ | | - |

| | | Comp. Ex. 1 | | | | | Comp. Ex. 2 | | | | |
|---|---|---|---|---|---|---|---|---|---|---|---|
| Layer | | Phase shift film | Light shielding film | Hard mask film | | Resist film | Phase shift film | Light shielding film | Hard mask film | | Resist film |
| | | | | Lower layer | Upper layer | | | | Lower layer | Upper layer | |
| Composition | | MoSi | Cr | - | TaOx | - | MoSi | Cr | Si | TaOx | - |
| Film thickness (nm) | | 75 | 30 | - | 5 | 160 | 75 | 30 | 3 | 2 | 126 |
| F-based etching processability | Etching rate ratio (to Comp. Ex. 1) | - | | 1.0 | | - | - | | 2.3 | | - |
| | Evaluation | - | | ○ (Reference value) | | - | - | | ⊚ | | - |
| Conductivity | Electrical resistivity (Ω·m) | - | | 1.50 × 10⁻⁷ | | - | - | | 3.97 × 10³ | | - |
| | Evaluation | - | | ○ | | - | - | | × | | - |

### Reference Signs List

- 1: translucent substrate
- 2: phase shift film
- 2a: phase shift film pattern
- 3: light shielding film
- 3a, 3b: light shielding film pattern
- 4: hard mask film
- 41: lower layer
- 42: upper layer
- 4a: hard mask pattern
- 41a: lower layer pattern
- 42a: upper layer pattern
- 5a: resist pattern
- 6b: resist pattern
- 100: mask blank
- 200: phase shift mask

## Claims

1. A photomask blank used to manufacture a photomask to which exposure light having a wavelength of 200 nm or less is applied, the photomask blank comprising, in the following order:
a transparent substrate;
a thin film; and
a hard mask film,
wherein the thin film is formed of a material containing chromium,
the hard mask film includes a lower layer positioned on a side of the thin film, and an upper layer configuring an outermost layer of the hard mask film,
the lower layer contains at least one selected from tungsten, tellurium, ruthenium, and a compound of tungsten, tellurium, or ruthenium,
the upper layer contains tantalum or a tantalum compound, and
the compound contains at least one selected from oxygen, nitrogen, and carbon.

2. The photomask blank according to claim 1, wherein a thickness of the upper layer is 1 nm or more.

3. The photomask blank according to claim 1 or 2, wherein a thickness of the hard mask film is in a range of 4 nm or more and 14 nm or less.

4. The photomask blank according to any one of claims 1 to 3, wherein the thin film is a light shielding film.

5. The photomask blank according to claim 4, further comprising:
between the transparent substrate and the light shielding film, a phase shift film consisting of a material containing silicon.

6. A photomask to which exposure light having a wavelength of 200 nm or less is applied, the photomask comprising:
a transparent substrate;
a thin film which is formed on the transparent substrate and on which a pattern is formed; and
a hard mask film formed on the thin film,
wherein the thin film is formed of a material containing chromium,
the hard mask film includes a lower layer positioned on a side of the thin film, and an upper layer configuring an outermost layer of the hard mask film,
the lower layer contains at least one selected from tungsten, tellurium, ruthenium, and a compound of tungsten, tellurium, or ruthenium,
the upper layer contains tantalum or a tantalum compound, and
the compound contains at least one selected from oxygen, nitrogen, and carbon.

7. The photomask according to claim 6, wherein a thickness of the upper layer is 1 nm or more.

8. The photomask according to claim 6 or 7, wherein a thickness of the hard mask film is in a range of 4 nm or more and 14 nm or less.

9. The photomask according to any one of claims 6 to 8, wherein the thin film is a light shielding film.

10. The photomask according to claim 9, further comprising:
between the transparent substrate and the light shielding film, a phase shift film consisting of a material containing silicon.

11. A method for manufacturing a photomask using the photomask blank according to any one of claims 1 to 4, the method comprising:
forming a resist pattern on the hard mask film of the photomask blank;
forming a hard mask pattern by performing dry etching on the hard mask film with a fluorine-based gas using the resist pattern as a mask; and
forming a thin film pattern by performing dry etching on the thin film with a mixed gas of chlorine and oxygen using the hard mask pattern as a mask.

12. A method for manufacturing a photomask using the photomask blank according to claim 5, the method comprising:
forming a resist pattern on the hard mask film of the photomask blank;
forming a hard mask pattern by performing dry etching on the hard mask film with a fluorine-based gas using the resist pattern as a mask;
forming a light shielding film pattern by performing dry etching on the light shielding film with a mixed gas of chlorine and oxygen using the hard mask pattern as a mask; and
removing the hard mask pattern while forming a phase shift film pattern by performing dry etching on the phase shift film with a fluorine-based gas using the light shielding film pattern as a mask.
